# EUROPEAN PATENT SPECIFICATION

(11) **EP 0 826 969 B1**
(45) Date of publication and mention of the grant of the patent: **20.11.2002**
(21) Application number: 97115019.8
(22) Date of filing: 29.08.1997
(51) Int. Cl.: G01R 1/073

(54) **Substrate inspection apparatus and method therefore**
Schaltplatinenprüfvorrichtung und Verfahren dafür
Appareil de contrôle de circuits imprimés et procédé correspondant

(30) Priority: 29.08.1996 JP 22827096
(43) Date of publication of application: 04.03.1998
(73) Proprietor: Nidec-Read Corporation, Uji-shi, Kyoto 611 (JP)
(72) Inventor: Nishikawa, Hideo, Higashiyama-ku, Kyoto 605 (JP)
(74) Representative: von Fischern, Bernhard, Dipl.-Ing.

(56) References cited:
- EP-A- 0 661 545
- EP-A- 0 662 614
- DE-A- 4 406 674
- GB-A- 2 274 211
- PATENT ABSTRACTS OF JAPAN vol. 017, no. 220 (P-1529), 30 April 1993 -& JP 04 355379 A (JAPAN SYNTHETIC RUBBER CO LTD), 9 December 1992

## Description

### FIELD OF INVENTION

The present invention relates to a substrate inspection apparatus according to the preamble of claim 1 and a related method. In particular, the present invention is adapted to the inspection of, e.g., printed circuit boards and related substrates.

### STATE OF THE ART

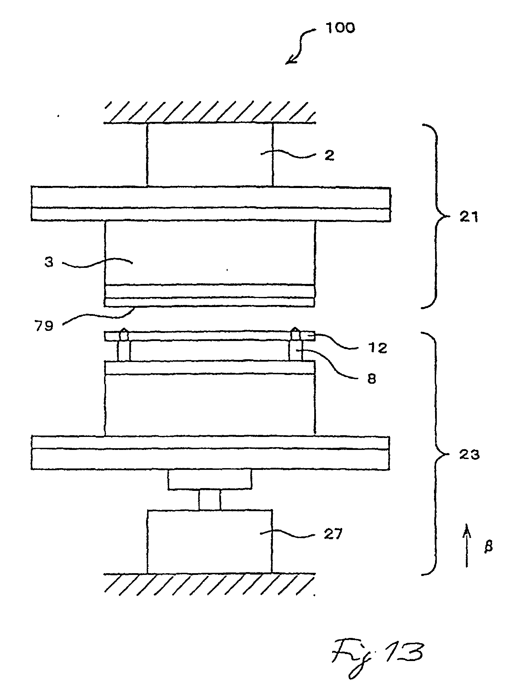

A printed circuit board inspection apparatus 100 being related to background art is shown in Fig. 13. The printed circuit board inspection apparatus 100 comprises an upper inspection jig 21 and a lower inspection jig 23. The lower inspection jig 23 has guide posts 8. A circuit board 12 to be inspected is located on the guide posts 8. The lower inspection jig 23 is driven by a lifting device 27 in the direction indicted by the arrow β and in the opposite direction in a controlled fashion. The upper inspection jig 21 has an X-Y-θ drive device 2; a universal jig 3; and a rubber jig 79. The X-Y-θ drive device 2 changes the relative positions of the upper inspection jig 21 and the lower inspection jig 23, respectively.

In the printed circuit board inspection apparatus 100 shown in Fig. 13, the upper inspection jig 21 is positioned relative to the inspected circuit board 12 by the following method.

A pattern film is used during manufacturing of the circuit board 12 and is adhered temporarily to a rubber jig 79 by an operator. A double coated adhesive tape is adhered to the surface of the inspected circuit board 12, and the lifting device 27 moves the lower inspection jig 23 along the direction indicated by the arrow β. This operation allows the adhesion of the pattern film to the inspected circuit board 12.

The operator then observes the misalignment between the pattern film and the inspected printed board, and uses an X-Y-θ drive device 2 to fine-adjust the horizontal position of the upper inspection jig 21.

Since this operation is repeated in a try-and-error fashion to adjust relative positions of the upper and the lower inspection jigs 21 and 23, in such a process, positioning is achieved in the abutting state, i.e., under the same conditions as those where the conductivity of circuit board is inspected. This method, however, requires complicated works.

To avoid this complicated works, it is possible to adjust the position of the upper inspection jig with a camera as disclosed in Japanese Patent Application Laid-Open No. 1-184473 inserted and removed into and from the gap between the jigs of the apparatus. With this method, however, the positioning is made with the upper and lower jigs being apart from each other, resulting in a misalignment in a contacted state.

According to another approach, the pattern film is a film which was used for forming a pattern of the printed circuit board to be inspected. Such film has the same circuit pattern as that of the inspected printed board. The film is adhered to a pitch conversion plate with the pattern of the film being matched to the pattern of electrodes of the conversion plate accurately. Then, a printed circuit board with double coated adhesive tape attached thereon is brought into press contact with the film so that the film is adhered to the printed board. After that, the lower jig is lowered, and the operator checks the relative portion of the film and board which position represents the relative position of the conversion plate and the circuit board. This approach, too, requires complicated and time consuming processing steps.

Finally, in JP-A-04355379 there is described an apparatus for inspecting printed circuit boards comprising a lower position detecting camera 52 detecting the positional shift of an under surface pattern electrode 12 to an under surface inspection electrode 31 when a printed circuit board 10 to be inspected is arranged above a lower inspection jig 30 through a gap in opposed relationship. Further, an upper position detecting camera 53 detects the positional shift of an upper surface pattern electrode 11 to an upper surface inspection electrode 21 when the board is held to the upper surface of the jig in a contact state. A lower inspection jig moving cable 54 receives the detection signal from the camera 52 to move the jig 30 so as to correct the positional shift state of the electrode 12 to the electrode 31 and receives the detection signal from the camera to move the jig 30 having the board 10 held thereto for correcting the positional shift state of the electrode 11 to the electrode 21.

### SUMMARY OF THE INVENTION

In view of the above, the object of the present invention is to provide a substrate inspection apparatus that can simply and accurately position the substrate to be inspected with respect to an electrode region of the substrate inspection apparatus.

According to the invention, this object is achieved with a substrate inspection apparatus having the features of claim 1.

Thus, according to the present invention, the upper positioning jig is set at the position where the substrate to be inspected is set. Further, the upper inspection jig has an upper reference mark located at a specified distance apart from a region to be inspected along a specified direction such that the range of the region is defined by, e.g., a plurality of guides for supporting the substrate to be tested and the positioning plate. Further, the upper reference mark is formed to be aligned with the lower reference mark. A position adjustment means moves the upper inspection jig or the lower inspection jig relative to each other until they are brought into abutment. Then, the position adjustment means determines a misalignment between the positioning plate and the upper inspection jig based on images taken with the positioning plate abutting against the upper inspection jig. Then, the position adjustment means adjusts the relative positions of the upper inspection jig and the lower inspection jig based on the determined misalignment.

A major advantage of the invention is that the upper and lower reference mark is located outside of the electrode region of the upper inspection jig. As a result, even if a camera to take pictures cannot be installed the electrode region of the upper inspection jig, in a substrate inspection apparatus with universal type jigs, the position of the upper inspection jig may be simply and accurately determined in an abutting state.

Further, positioning of the upper inspection jig is made in a state in which an actual conductivity test is conducted, that is in an abutting state. Thus, errors are unlikely to occur and the detection accuracy is high. Further, the lower reference mark in the positioning plate and upper reference mark are simultaneously detected on substantially the same plane with equivalent light reflecting conditions. Thus, the effect of errors in the accuracy of the image taking means is small and the adjusting operation is facilitated.

According to a preferred embodiment of the present invention the upper reference mark is composed of a through hole. Also, the lower reference mark consists of a through hole having a smaller diameter than that of the upper reference mark. In case the surface of the positioning plate is made of high reflectance material with high light reflectance clear binary images may be obtained and used to determine the amount of misalignment between the upper reference mark and the lower reference mark when the upper inspection jig abuts the positioning plate. In addition, the positioning plate can be simply made by using a material similar to that of the substrate to be inspected, e.g., a printed circuit board, forming the lower inspection hole at a specified distance apart from the inspected regions along specified directions.

According to yet another preferred embodiment of the present invention the upper inspection jig is composed of a universal jig and a pitch conversion board with an electrically conductive rubber portion such that the upper reference mark is formed on the pitch conversion board. Therefore, for the universal jig the upper inspection jig may also be positioned accurately relative to the substrate to be inspected.

According to yet another preferred embodiment of the inventive substrate inspection apparatus, the positioning plate is composes of a high reflectance member. Here, either a part of the positioning plate is made high reflectance material or the entire positioning plate is made of a high reflectance material. Besides a copper foil plate, the high reflectance member may be made of a metallic plate, e.g., an aluminum foil or any other material having comparable characteristics.

Further, the object outlined above is achieved through a substrate inspection method where initially instead of the substrate to be tested a positioning plate is supported by a low inspection jig. Here, an inspection region being used for subsequent inspection of the substrate is defined by a plurality of guides for supporting the support to be inspected. According to the method, an upper reference mark is formed at a position to be aligned with a lower reference mark and on the basis of the upper reference mark and the lower reference mark a relative position adjustment step is carried out to align the upper reference mark and the lower reference mark. Thus, the method according to the invention allows to simply and accurately determine a correctly aligned position of a substrate to be inspected with respect to an electrode region of a substrate inspection apparatus in an abutting state. Also, errors are unlikely to occur and the detection accurately is high.

According to a preferred embodiment of the inventive method, an image forming means is used within the position adjustment step which is held outside the electrode region of the upper inspection jig. Here, the reference mark of the upper inspection jig is formed on the upper inspection jig at a position where the picture of the upper reference mark is taken by the image forming means. Based on obtained images of the upper reference mark and the lower reference mark, in particular the relative position thereof, the amount of misalignment between the positioning plate and the upper inspection jig may be calculated and then, based on the results of calculation, the upper inspection jig and the lower inspection jig may be displaced relative to each other. Thus, an accurate position of the upper inspection jig and the lower inspection jig is achieved. In addition, positioning may be executed in an abutting state to avoid misalignment during abutting operation. This means that once an alignment between relevant parts is achieved and no separation takes place that might eventually again introduce a misalignment. Overall, according to the invention the upper inspection jig may be simply and accurately positioned relative to the substrate to be inspected.

According to a preferred embodiment of the inventive method, there is used an upper inspection jig which is composed of a universal jig and a pitch conversion board with a conductive rubber portion having reference marks formed in the pitch conversion board. Thus, the universal jig may also be positioned accurately relative to the substrate to be inspected.

According to yet another preferred embodiment of the inventive method, reference marks are formed beforehand in a creation film having a pattern formed thereon in a conductive rubber portion such that the reference marks are related to the pattern. The creation film is loaded in such a way that it aligns with the pattern of the conductive rubber portion. Here, the pattern reference mark and the reference mark formed are taken to measure the amount of any pattern misalignment between them. Therefore, correction is conducted by considering the amount of pattern misalignment between the conductive rubber portion of the pitch conversion board. Therefore, this preferred embodiment of the inventive method enables simple and accurate positioning even if the conductive rubber portion is misalignment relative to the pitch conversion board.

### BRIEF DESCRIPTION OF THE FIGURES

Preferred embodiments of the invention will be described with reference to the drawings in which:
- Fig. 1: shows the overall configuration of the substrate inspection board according to the invention,
- Fig. 2: shows a diagonal view of a positioning plate,
- Fig. 3: shows a pitch conversion board and the positioning plate at an abutting state,
- Fig. 4: shows a cross-sectional view of the pitch conversion board,
- Fig. 5: shows a misalignment of unevenly distributed press conductive rubber PCR portions,
- Fig. 6: shows a system configuration of the substrate inspection apparatus according to the invention,
- Fig. 7: shows a flow chart according to the positioning process within the substrate inspection apparatus according to the invention,
- Figs. 8a and 8b,: respectively,
show images of first and second positioning holes as viewed by a imaging camera,
- Fig. 9: shows an example for the amount of misalignment to be calculated,
- Fig. 10: shows a further embodiment for the provision of an upper reference mark and a lower reference mark according to the invention,
- Fig. 11: shows a cross-sectional view of another pitch conversion board according to the invention,
- Fig. 12: shows a mounting construction for an imaging camera,
- Fig. 13: shows a substrate inspection apparatus according to background art.

### DESCRIPTION OF PREFERRED EMBODIMENTS

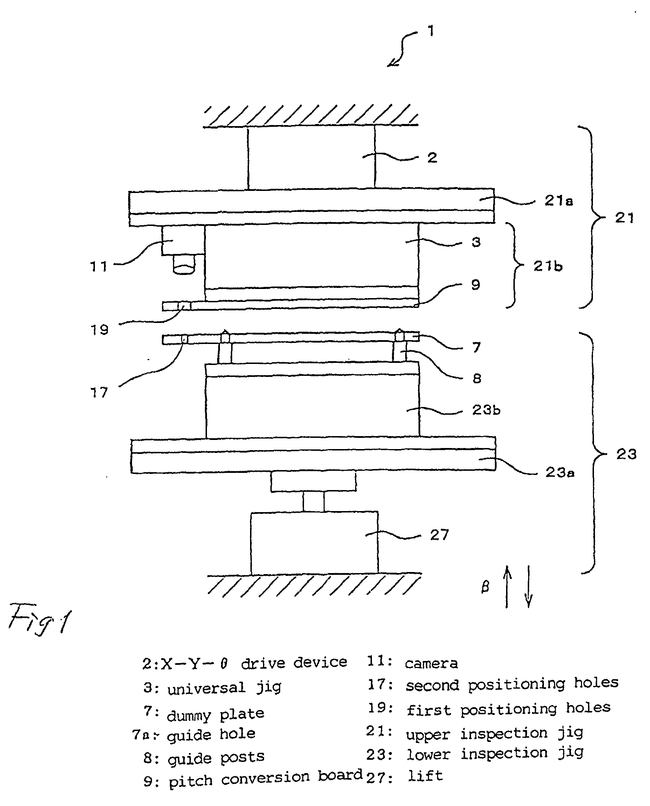

An embodiment of the present invention will be described with reference to Fig. 1 that shows a schematic diagram of a printed circuit board inspection apparatus 1 with an upper-jig positioning mechanism.

The printed circuit board inspection apparatus 1 is made of an upper inspection jig 21 and a lower inspection jig 23. The upper inspection jig 21 includes an X-Y-θ drive device 2, an upper base plate 21a, two cameras 11, and an upper inspection section 21b. The upper inspection section 21b includes a universal jig 3 and a pitch conversion board 9.

A lower inspection jig 23 has a lower holding section 23b and guide posts 8 on a lower base plate 23a. Dummy board 7 is positioned and held on the guide posts 8 instead of a printed circuit board to be inspected. A first positioning hole 19 has a larger diameter than the second positioning hole 17. The diameter of the first positioning hole 19 is preferably 1.2 to 3 times as large as that of the second positioning hole 17.

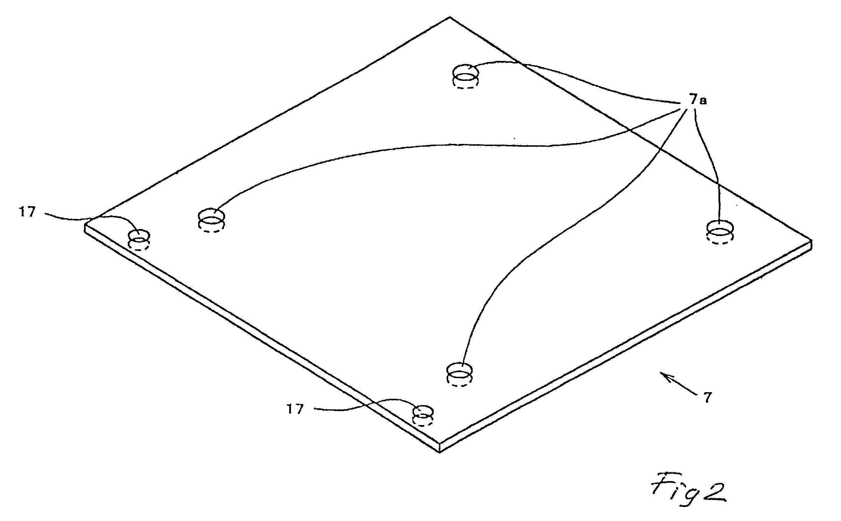

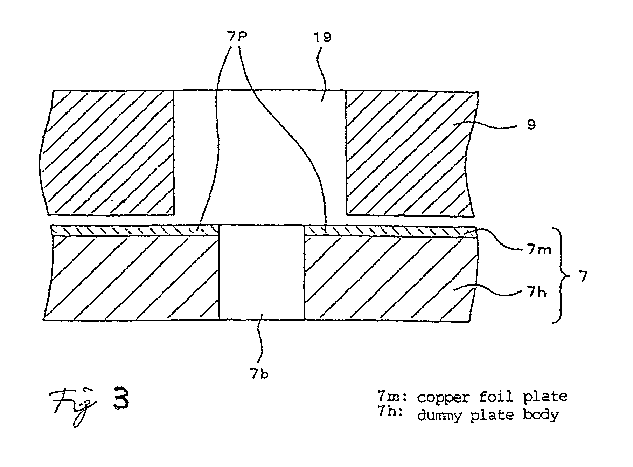

As shown in Fig. 2, the dummy plate of the printed circuit board apparatus is formed with guide holes 7a and a pair of second positioning holes 17. The guide holes 7a are formed with the same pitch as the guide holes formed in circuit board to be inspected. The range defined by the guide holes 7a corresponds to the region of printed circuit board that is actually inspected. Such range is referred to as inspection range, hereinafter. The second positioning holes 17 are formed at specified distances in specified directions from the inspection range. The dummy plate 7 is made of a copper foil plate 7m and a dummy plate body 7h, as shown in Fig. 3.

As shown in Fig. 1, two cameras 11 are mounted on the bottom surface of an upper base plate 21a so as to be coaxial with the first positioning holes 19, respectively. The cameras 11 are placed outside of the region of the pitch conversion board 9 where the pattern of the inspection-side electrodes 9c is formed, and the first positioning holes 19 are formed on the pitch conversion board 9 coaxially with the optical axis of the cameras 11, respectively. Instead of the printed circuit board, the dummy plate 7 is positioned and supported on the guide posts 8 on the lower inspection jig 23. The second positioning holes 17 are formed at specified distances in specified directions from the inspection range of the dummy plate 7.

Finally, according to Fig. 1, the lower inspection jig 23 is driven by a lift 27 in or opposite to the direction indication by the arrow β.

According to this embodiment, the number of cameras 11 and positioning holes 19 is two. This number is most preferable but may be one and more than two. In case of a single set, the cross sectional shape of the positioning hole 19 should be non-circular shape to detect angular deviation between the upper and lower inspection jigs 21 and 23, respectively.

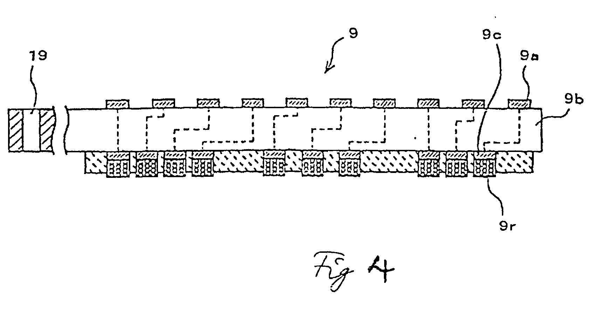

Further, the pitch conversion board shown in Fig. 4 is used for the inspection of a printed circuit board with pitches smaller than the inter-probe pitch of universal-type jigs, and manufactured with a pattern that aligns with the pattern of the printed circuit board.

The pitch conversation board 9 has probe-side electrodes 9a and inspection-side electrodes 9c on a body 9b. Unevenly distributed pressed conductive rubber (PCR) portions 9r are installed on the side of the inspection electrodes 9c. The pitch conversion board 9 has a pair of first positioning holes 19 located at specified distances in specified direction from the region in which the pattern of the inspection-side electrodes 9c is formed. According to this embodiment, "Offgrit Adapter JP2,000" manufactured by Japan Synthetic Rubber Inc. is used as the pitch conversion board 9.

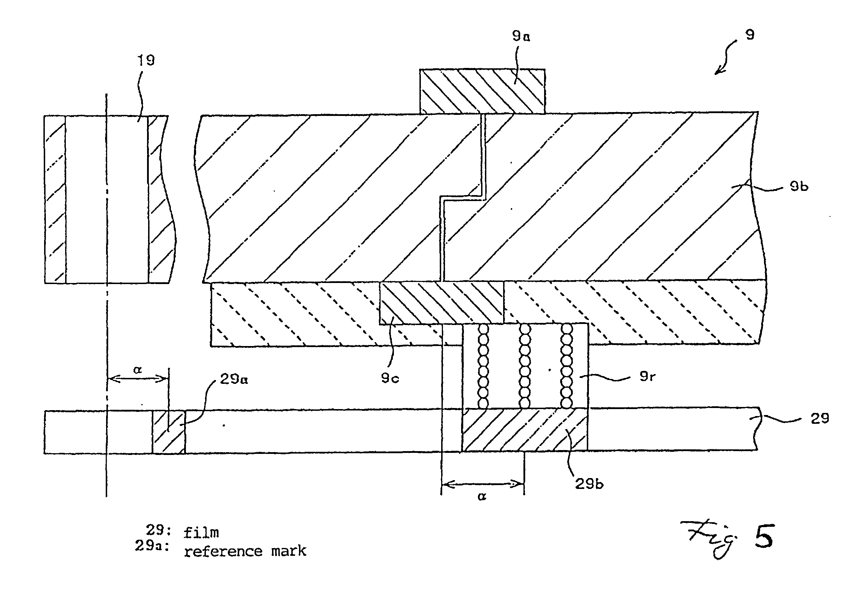

As shown in Fig. 5, pitch conversion plate 9 has rubber electrodes which are pressed against inspection side electrodes 93 and other points of a printed circuit board to be inspected. The structure of the rubber electrode shown in Fig. 5 as designated by 9r and electrically conductive members are embedded to electrically connect between the terminal of the inspected board and the inspection side electrode 9c.

Further, universal jig 3 according to this embodiment is a device adapted for inspection of printed circuit boards of various patterns. The universal jig 3 has many inspecting side electrodes 9c and probe side electrodes 9a connected to a circuit for detecting conductivity between and among particular electrodes. Thus, the pitch conversion board 9 is used to adapt the arrangement of the inspection electrodes 9c to the pattern of the printed circuit board electrodes to be inspected.

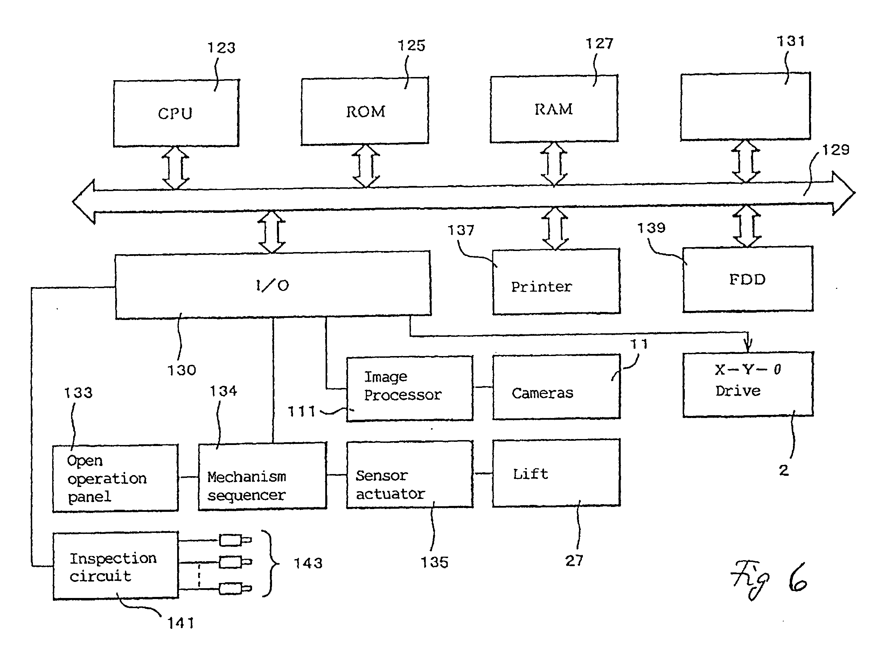

Fig. 6 shows a hardware system configuration of the printed-substrate inspection apparatus 1 according to the invention.

The printed circuit board inspection apparatus 1 comprises a CPU 123, a ROM 125, a RAM 127, a monitor 131, an FDD (floppy disk drive) 139, a printer 137, and I/O interface 130, and a bus line 129. Thus, the CPU 123 controls each section via a bus line 129 in accordance with a control program stored in the ROM 125.

The monitor 131 displays the operating state of the apparatus and image data obtained by the cameras 11. A flexible disc that stores data of preset conductivity of the inspected circuit board between the probes is inserted in the FDD 139. The printer 137 prints data indicating whether the detected conductivity of a printer circuit board between the probes match the preset conductivity data.

A mechanism sequencer 134, an image processor 111, and an inspection circuit 141 are connected to the I/O interface 130. A mechanism operation panel 133 is connected to the mechanism sequencer 134. The lift 27 is also connected to the mechanism sequencer 134 via a sensor actuator 135. The sensor actuator 135 comprises a combination of a sensor that detects the operation of the mechanism section and an actuator 25 for operating the mechanism. In particular, the sensor actuator 135 is constructed to detect a top-end detection signal when the lift 27 has been driven to a specified position. An image processor 111 digitalizes image data obtained by the cameras 11.

The inspection circuit 141 receives conductivity data from probes 143, processes the data, and supplies the processed data to the CPU 123 via the I/O interface 130. The data of detected conductivity are output to the printer 137. The CPU 123 reads present conductivity data for the printed circuit board to be inspected from the floppy disc held in the FDD 139. The CPU 123 then compares the present data with the detected data stored in the RAM 127 and read by the inspection circuit 141. This causes the results of the inspection to be output from the printer 137.

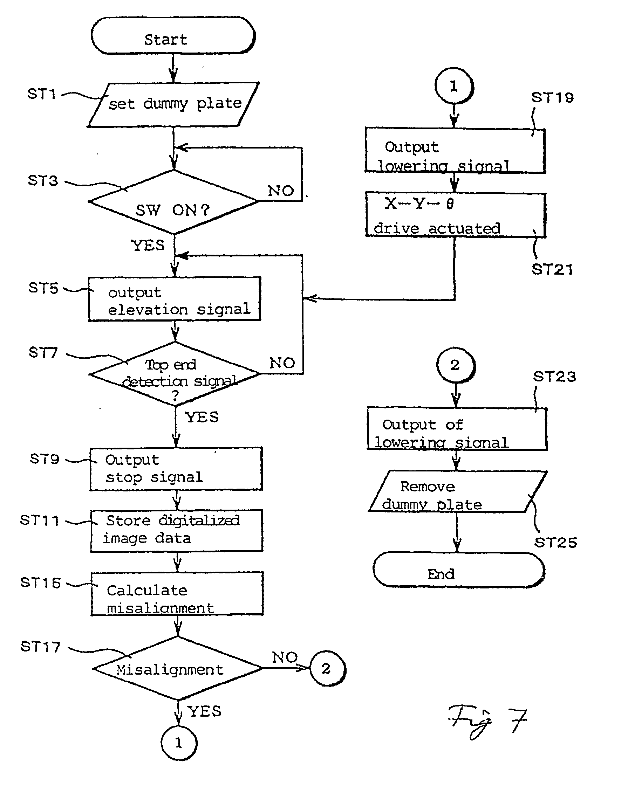

Next, the method for positioning the upper inspection jig 21 of the printed circuit board inspection apparatus 1 will be made with respect to Fig. 7.

The operator sets the dummy plate 7 on the guide posts 8 (step ST1). The mechanism sequencer 134 the determines whether the switch on the mechanism operation panel 133 has been pressed by the operator (step ST3). If so, the mechanism sequencer 134 outputs an elevation signal to the sensor actuator 135 (step ST5).

Then, the mechanism sequencer 134 determines whether a top-end detection signal has been provided by the sensor actuator 135 (step ST7), and if not, continues the process of step ST5.

If, at step ST7, a top-end detection signal is provided, a stop signal is output (step ST9). At this time the dummy plate 7 abuts the pitch conversion board 9.

The image processor 111 then digitalizes image data from the cameras 11, and the CPU 123 stores this data in the RAM 127 (step ST11).

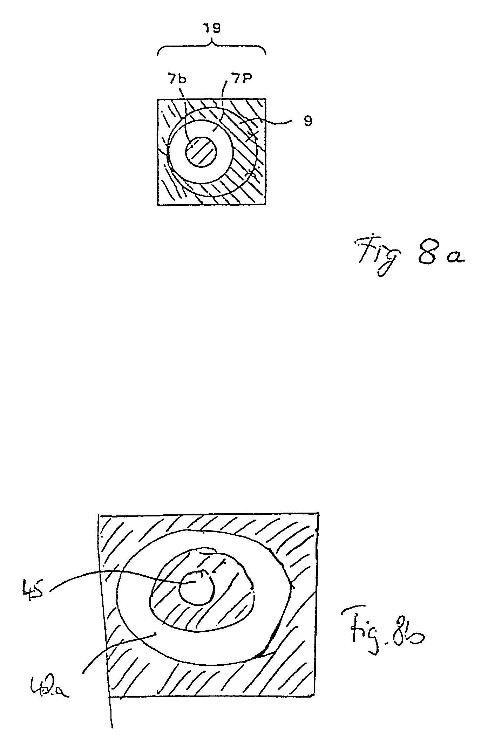

The image data obtained by the cameras 11 at step ST11 is explained with reference to Figs. 3 and 8. As shown in Fig. 3, a reflecting surface 7p has a hole of a smaller diameter than that of the first positioning hole 19 and the surface of the dummy plate 7 is formed of the copper foil plate 7m. Thus, light is reflected by the reflecting surface 7p to provide image data with dark holes, as shown in Fig. 8a. Here, image data is composed of two kinds of areas such as black and white area or high and low reflective area.

The dummy plate 7 does not abut the pitch conversion board 9. This is because the unevenly distributed PCR portions 9r protruding slightly from the pitch conversion board 9 abut the copper foil plate 7m of the dummy plate 7.

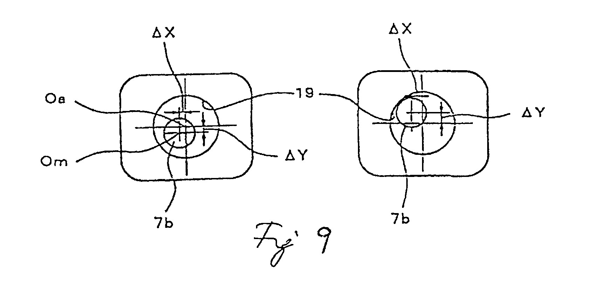

As shown in Fig. 7, the CPU 123 then calculates the amount of misalignment based on the digitalized data stored in the RAM 127 (step ST15). Here, the two oppositely formed positioning holes 17 are detected by the respective cameras 11 to measure the deviation ΔX and ΔY between the centre Oa of the contour of the first positioning hole 19 and the centre Om of the contour of the second positioning hole 17 in the directions of the X and the Y axes, respectively, as shown in Fig. 9. Based on the detected values, the amount of misalignment of the dummy plate 7 in the directions of the X and the Y axes and in the rotating direction around the vertical axis is calculated.

The CPU 123 thus determines whether the dummy plate 7 and the pitch conversion board 9 are misaligned, and if so, outputs a control signal for commanding the mechanism sequencer 134 to output a lowering signal (step ST19). This operation releases the dummy plate 7 and the pitch conversion board 9 from abutment.

As shown in Fig. 7, the CPU 123 outputs a drive signal to the X-Y-θ drive device 2 to move or displace the upper inspection jig 21 by an amount of detected misalignment (step ST21). This operation enables the upper inspection jig 21 to be brought in a correct position relative to the inspected printed circuit board at an abutting state, in accordance with the relative positions of the first and the second positioning holes 19 and 17, respectively.

After the process of steps ST5 through ST15 is eventually repeated, at step ST17 it is finally detected that there is no misalignment. The process proceeds to step ST23 to output a control signal for commanding the mechanism sequencer 134 to output a lowering signal. Thus, the lower inspection jig 23 releases the dummy plate 7 and the pitch conversion board 9 from abutment. The operator then removes the dummy plate 7 (step ST25).

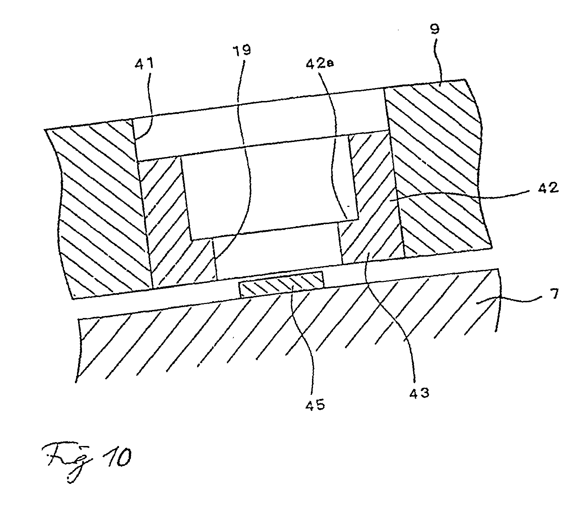

Another embodiment of the dummy plate 7 and the pitch conversion board 9 according to the invention is shown in Fig. 10. Here, a cylindrical through hole 41 is formed in the pitch conversion board 9 with a cup-like metallic (for example, stainless steel) bush 42 fitted inside at the bottom of the through hole 41. The metallic bush 42 has a reference hole 44 formed on its bottom plate 43. The reference hole 44 corresponds to a reference mark 45 on the dummy plate.

The reference mark 45 may be formed such that a glass-fiber mixed epoxy resin layer of the dummy plate 7 is exposed leaving the part of the reference mark 45. Otherwise the reference mark 45 may be formed by printing a circle on a conductor, e.g., copper or solder.

According to this embodiment, when the lift is elevated with the dummy plate 7 abutting the pitch conversion board, a digitalized image is obtained in which the surfaces of the land 42a of the bush 42 and the reference mark 45 are bright, while the remaining parts are dark. Thus, the boundary between the outer circumference of the reference mark 45 and the inner circumference of the reference hole 44 is clearly visible. The black and white portions in this image are reversed from the ones of those in the image data shown in Fig. 8a.

In addition, the upper inspection jig reference mark 45 consists of the first positioning holes 19 that are through holes according to the present embodiment. This construction facilitates forming of the image of the second positioning holes 17 through the first positioning holes 19. Any kind of marks, however, can be used as long as they can detect the misalignment between the upper jig reference marks and the positioning plate reference marks to be detected. For example, the pitch conversion board 9 may be composed of a transparent or semi-transparent material, and donut-like marks larger than the positioning plate reference marks may be used as the upper-jig reference marks through which the image of the positioning plate reference marks can be taken.

A further embodiment of the invention in accordance with Fig. 10 tackles the problem that misalignment is likely to occur between the unevenly distributed PCR portions 9r and the body 9b, when the pitch conversion board 9 as shown in Fig. 4 is used. That is, after the probe-side electrodes 9a and the inspection-side electrodes 9c have been formed on the body 9b, PCR portions are formed on the electrode 9c.

As shown in Fig. 5 this problem can be solved by forming at least one reference mark 29a on a positive film 29, which is used to form the unevenly distributed PCR portions 9r. The reference mark 29a is formed at the time of positive film forming, so as to have a predetermined relationship with the unevenly distributed PCR portions 9r.

Further, a pattern portion 29b of the positive film 29 is temporarily adhered to the pitch conversion board 9 in such a way that the pattern portion 29b aligns with the pattern of the unevenly distributed PCR portions 9r. The pitch conversion board 9 is mounted on the universal jig 3, and the cameras 11 are used to take pictures of image, the first positioning holes 19 and the reference marks 29a in the positive film 29. The amount of misalignment between the first positioning holes 19 and the reference marks 29a on the positive film 29 is calculated and stored.

In this case, the inspection-side electrodes 9c on the body 9b and the first positioning holes 19 are in a predetermined relationship, respectively. In addition, the reference marks 29a and the unevenly distributed PCR portions 9r are formed so as to have a predetermined relationship. If the unevenly distributed PCT portions 9r are offset from the inspection-side electrodes 9c by a distance α, also the first positioning holes 19 are offset from the reference marks 29a by the distance α. Thus, misalignments occurring when the unevenly distributed PCR portions 9r formed on the body 9b can be corrected.

Therefore, according to the invention in determining the relationship between the dummy plate 7 and the pitch conversion board 9, as described above, correction can be made with the amount of misalignment α taken into consideration. In particular, the amount of misalignment α can be automatically corrected after positioning has been finished.

According to the present invention, the positive film 29 is used as a creation film. Since the pattern portion of the positive film is dense while the remaining parts are transparent, it can be temporarily adhered easily with the pattern portion being aligned with the pattern of the unevenly distributed PCR portions 9r. The present invention, however, is not limited to such positive film, and a negative film may be used.

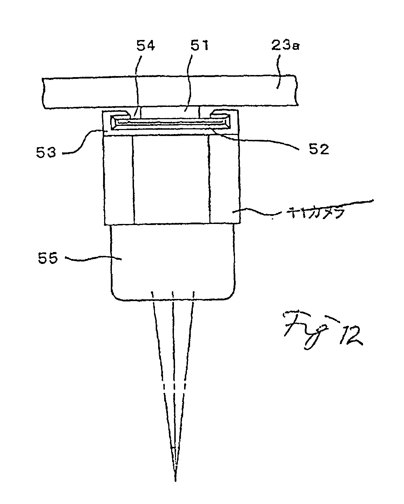

Another embodiment of the invention shown in Fig. 12 relates to the attachment of the cameras. In particular, the camera 11 may be fixed to the upper base plate 23a of the upper inspection jig 23 or removably mounted thereto. As shown in Fig. 12, a camera rail 52 is mounted on the upper base plate 23a via a rail spacer 51. A base 53 with a T-shaped groove 54 is formed at the end of the camera 11. The T-shaped groove 54 is engaged with the camera rail 52. A lighting device 55 may have a ring shape.

Overall, according to the present embodiment, the first positioning holes 19 are formed at specific distances in specified directions from the probe holding region of the pitch conversion board 9, the cameras 11 are mounted such that its taking lens is coaxial with the first positioning holes 19, and the second positioning holes 17 are formed at specified distances in specified directions from the inspection region of the dummy plate 7, which is opposed to the probe holding region. Consequently, while the dummy plate 7 and the pitch conversion board 9 are abutting each other, image data can be read from the cameras 11 to calculate the amount of misalignment. The camera 11 may be somewhat removed from coaxial position as long as the camera 11 can take a picture of the first positioning hole 19.

Although the invention has been described with reference to the case where a rubber jig is used as the pitch conversion board, this invention is also applicable to the case where spring probe is used. The same can be said with the case when such rubber jigs are not used.

Still further, the present invention is applicable to the case where the printed board inspection apparatus includes an exclusive jig instead of the universal type jig and the cameras cannot b e installed inside the exclusive jig (the electrode region of the upper jig).

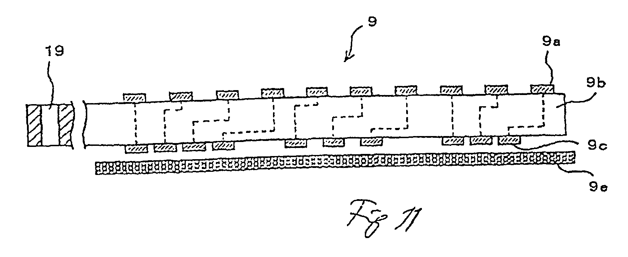

Although the present embodiment employed the pitch conversion board 9 as shown in Fig. 4, a pitch conversion board 9 such as that shown in Fig. 11 may be employed. An example of such a pitch conversion board is "Offgrit Adapter 11 JP,1000" manufactured by Japan Synthetic Rubber Inc.

Still further, although the present embodiment has been described wherein the second positioning holes 17 are formed on the dummy plate 7 as the positioning reference marks, instead a reference mark 45 may be formed as a positioning plate reference mark with a bush 42 embedded in the pitch conversion board 9, as shown in Fig. 10.

Still further, while in the above-mentioned embodiments the printed circuit board inspection apparatus 1 automatically corrects the position of the upper inspection jig 3, the printed circuit board inspection apparatus of the present invention may be constructed such that, after the cameras 11 detect the position of the upper inspection jig 3, the operator manually corrects the position of the upper inspection jig, observing the monitor.

Finally, while in the above-described embodiments the mechanism sequencer 134 is used with a CPU in order to achieve the required functions described above, all the functions may be performed by CPU and its software. In addition, part or all of the functions may be formed by hardware such as logic circuits.

### List of Reference Numerals

- 2: X-Y-θ driving device
- 3: universal jig
- 7: dummy plate or positioning plate, respectively
- 7a: guide hole
- 7h: dummy foil plate
- 7m: copper foil plate
- 7p: reflecting surface
- 8: guide posts
- 9: pitch conversion board
- 9a: probe side electrodes
- 9b: body
- 9c: inspection side electrodes
- 11: camera
- 12: inpsected substrate, end board, respectively
- 17: upper or second positioning holes
- 19: lower or first positioning holes
- 21: upper inspection jig
- 21a: upper base plate
- 23: lower inspection jig
- 23b: lower holding section
- 29: film
- 29a: reference mark
- 41: cylindrical through hole
- 42: cup-like metallic bush
- 44: reference hole
- 51: rail space
- 52: camera rail
- 53: base
- 54: T-shaped grooves
- 55: lighting device
- 100: substrate inspection apparatus, in particular printed circuit board inspection apparatus being related to the background art
- 73: rubber jig
- 111: image processors
- 123: CPU
- 124: ROM
- 127: RAM
- 129: bus line
- 130: I/O interface
- 131: monitor
- 133: mechanism operation panel
- 134: mechanism sequencer
- 135: sensor actuator
- 137: printer
- 139: floppy disc drive, FDD
- 141: inspection circuit
- 143: probe

## Claims

1. Printed circuit board inspection arrangement for inspecting electric conductivity between inspection points on circuit pattern formed in an inspection region on a printed circuit board to be inspected, said arrangement comprising:
a substantially horizontally extending upper jig (21) having an electrode region where a plurality of probes are arranged at universal pitches;
a lower jig (23) having guide means to support the printed circuit board at a position substantially horizontally thereon;
**characterized by**
a pitch conversion board (9) exchangeably mounted on said upper jig, said pitch conversion board having probe-side electrodes provided on the upper side of the board to be connected with the probes and inspection-side electrodes provided on the lower side of the board to be brought into contact with the inspection points, said probe-side electrodes being arranged to adapt for the universal pitch of the probes of the upper jig, said inspection-side electrodes being arranged to be connected with corresponding inspection points on the circuit pattern;
a first reference mark (19) formed on said pitch conversion board (9);
a removable positioning plate (7) held on the lower jig in place of the printed circuit board to be tested and having a second reference mark (17) located at specified position relative to a region corresponding to the inspecting region of the printed circuit board, said second reference mark (17) being formed at a position to be aligned with the first reference mark (19) when the pitch conversion board is at a matching position relative to the positioning plate (7) where the inspection-side electrodes align with the inspection points on the circuit board to be located in place of the positioning plate (7);
a vertical drive means (27) for causing relative movement of said upper jig (21) and lower jig (23) to bring said reference plate into engagement with said pitch conversion board;
a horizontal drive means (2) for causing relative movement of said upper jig (21) and lower jig (23) in horizontal directions;
an image forming means (11) associated with one of upper jig (21) and lower jig (23) for forming overlapping images of said first and second reference marks when said positioning plate (7) is in engagement with said conversion board (9);
means (123) for calculating the direction and amount of misalignment between said positioning plate (7) and said pitch conversion board (9) based on the overlapping images formed by said image forming means (11); and
control means for controlling the horizontal driving means (27) in accordance with the output of said calculating means (123) to bring said upper jig (21) and lower jig (23) into the relative position to match the conversion board (9) with the reference plate (7).

2. Printed circuit board inspection arrangement according to claim 1, **characterized in that**
the upper reference mark (19) is formed as a through hole in the electrode region lying outside relative to the pitch conversion board (9) and that the lower reference mark (17) is formed by a through hole having a smaller diameter than that of the upper reference mark (19) .

3. Method for horizontally positioning a pitch conversion board (9) relative to a printed circuit board to be inspected, with a circuit board inspection apparatus for inspecting electric conductivity between inspection points on circuit pattern on said printed circuit board, said apparatus including a substantially horizontally extending upper jig (21) having an electrode region where a plurality of probes are arranged at universal pitches, and a lower jig (23) having guide means (8) for horizontally supporting said printed circuit board, and an image forming means (11) associated with one of the upper jig and the lower jig, the method comprising the steps of:
mounting the pitch conversion board (9) on said upper jig (21), said pitch conversion board (9) having probe-side electrodes provided on the upper side of the printed circuit board to be connected with the probes and inspection-side electrodes provided on the lower-side of the printed circuit board to be brought into contact with the inspection points, said probe-side electrodes being arranged to adapt for the universal pitch of the probes of the upper jig (21), said inspection-side electrodes being adapted to be connected with corresponding inspection points, said pitch conversion board (9) having a first reference mark (19) at a position enabling image formation by said image forming means (11);
mounting a positioning plate (7) on the lower-jig guide means (8) at the location where a printed circuit board is to be mounted, said positioning plate (7) having a second reference mark (17) at position corresponding to said first reference mark (19);
driving one of said upper jig and lower jig vertically to bring said pitch conversion board (9) and said reference plate into engagement with each other;
taking overlapping images of said first reference mark (19) and said second reference mark (17) while said pitch conversion board (9) and positioning plate (7) are in engagement;
calculating the amount and direction of the misalignment between said positioning plate (7) and said pitch conversion board (9) based on the overlapping images taken;
adjusting the relative horizontal position of said lower jig and upper jig based on the result of the calculation to match the inspection side electrodes with corresponding inspection points.

4. Method according to claim 3, **characterised in that** in case the upper inspection jig (21) comprises a universal displacing mechanism and the pitch conversion board (9) with an electrically conductive rubber portion (9r) at a position corresponding to the electrode region, the calculation of the amount of misalignment is sub-divided into the following steps:
a) providing a pattern reference mark (29a) on a film (29) with which the conductive rubber portion (9r) is formed in a pattern, the pattern reference mark (29a) being located with reference to the conductive rubber portion (9r),
b) placing the film such that its pattern aligns with the pattern of the conductive rubber portion (9r), and
c) taking images of the pattern reference mark (29a) and the upper reference mark (19) and measuring the amount of misalignment of the pattern reference mark (29a) and the upper reference mark (19).

## Patentansprüche

1. Leiterplattenprüfungsanordnung zum Überprüfen elektrischer Leitfähigkeit zwischen Überprüfungspunkten auf Schaltungsmustern, die in einem Überprüfungsgebiet auf einer zu überprüfenden Leiterplatte ausgebildet sind, wobei die Anordnung umfasst:
eine im Wesentlichen sich horizontal erstreckende Spannvorrichtung (21) mit einem Elektrodenbereich, in dem eine Vielzahl von Sonden an Universal-Pitches angeordnet sind;
eine untere Spannvorrichtung (23) mit Führungsmitteln zum Tragen der Leiterplatte in einer im Wesentlichen horizontalen Position darauf;
**gekennzeichnet durch**
eine Pitch-Wandlerplatte (9), austauschbar montiert an der oberen Spannvorrichtung, wobei die Pitch-Wandlerplatte Sondenseitenelektroden hat, die angeordnet sind zum Anpassen des Universal-Pitch der Sonden der oberen Spannvorrichtung und die Untersuchungsseitenelektroden angeordnet sind, um mit entsprechenden Untersuchungspunkten an den Schaltungsmustern verbunden zu sein;
eine erste Referenzmarkierung (19), die ausgebildet ist an der Pitch-Wandlerplatte (9);
eine entfernbar angeordnete Platte (7), die an der unteren Spannvorrichtung an der Stelle der zu testenden Leiterplatte gehalten ist und eine zweite Referenzmarkierung (10) hat, angeordnet an spezifizierten Positionen relativ zu einem Bereich, der dem Untersuchungsbereich der Leiterplatte entspricht, wobei die zweite Referenzmarkierung (17) an einer Position ausgebildet ist, um ausgerichtet zu sein mit der ersten Referenzmarkierung (19), wenn die Pitch-Wandlerplatte in einer abgestimmten Position relativ zu der Positionierungsplatte (7) angeordnet ist, wobei die Untersuchungsseitenelektroden ausgerichtet sind mit den Untersuchungspunkten an der Leiterplatte, die an der Stelle der Positionierungsplatte (7) angeordnet ist,
ein Vertikalantriebsmittel (27) zum Bewirken einer Relativbewegung der oberen Spannvorrichtung (21) und der unteren Spannvorrichtung (27), um die Referenzplatte in Eingriff zu bringen mit der Pitch-Wandlerplatte;
ein Horizontalantriebsmittel (2) zum Bewirken einer Relativbewegung der oberen Spannvorrichtung (21) und der unteren Spannvorrichtung (23) in Horizontalrichtung;
ein Abbildungsmittel (11), das einer der oberen Spannvorrichtungen (21) und unteren Spannvorrichtungen (23) zugeordnet ist zum Bilden überlappender Abbildungen der ersten und zweiten Referenzmarkierungen wenn die Positionierungsplatte (7) in Eingriff ist mit der Wandlerplatte (9);
Rechenmittel (123) zum Berechnen der Richtung und des Betrags der Fehlausrichtung zwischen der Positionierungsplatte (7) und der Pitch-Wandlerplatte (9) basierend auf den überlappenden Abbildungen, die von dem Abbildungsmittel (11) erstellt worden sind; und
Steuermittel zum Steuern des Horizontalantriebsmittels (27) in Übereinstimmung mit der Ausgangsgröße des Rechenmittels (123), um die obere Spannvorrichtung (21) und die untere Spannvorrichtung (23) in die relative Position zu bringen, um die Wandlerplatte (9) an die Referenzplatte (7) anzupassen.

2. Leiterplattenüberprüfungsanordnung nach Anspruch 1,
**dadurch gekennzeichnet, dass**
die obere Referenzmarkierung (19) ausgebildet ist als Durchgangsloch in dem Elektrodenbereich, der relativ außerhalb zur Pitch-Wandlerplatte (9) liegt und dass die untere Referenzmarkierung (17) ausgebildet ist durch ein Durchgangsloch mit einem geringereren Durchmesser als dem der oberen Referenzmarkierung (19).

3. Verfahren zur horizontalen Positionierung einer Pitch-Wandlerplatte (9) relativ zu einer zu überprüfenden Leiterplatte, mit einer Leiterplattenüberprüfungs-Vorrichtung zum Überprüfen elektrischer Leitfähigkeit zwischen Überprüfungspunkten auf Schaltkreismustern an der Leiterplatte, wobei die Vorrichtung eine im Wesentlichen horizontal sich erstreckende Spannvorrichtung (21) einschließt mit einem Elektrodenbereich, in dem eine Vielzahl von Sonden angeordnet ist an Universal-Pitches und eine untere Spannvorrichtung (23) mit Führungsmittel (8) zum horizontalen Abstützen der Leiterplatte und einem Abbildungsmittel (11), das einem von der oberen Spannvorrichtung und der unteren Spannvorrichtung zugeordnet ist, wobei das Verfahren die Schritte umfasst:
Montieren der Pitch-Wandlerplatte (9) an der oberen Spannvorrichtung (21), wobei die Pitch-Wandlerplatte (9) Sondenseitenelektroden hat, die an der Oberseite der Leiterplatte vorgesehen sind, um verbunden zu werden mit den Sonden und Untersuchungsseitenelektroden, die an der Unterseite der Leiterplatte vorgesehen sind, um in Kontakt gebracht zu werden mit den Untersuchungspunkten, wobei die sondenseitigen Elektroden angeordnet sind zum Anpassen des Universal-Pitches der Sonden der oberen Spannvorrichtung (21), die Untersuchungsseitenelektroden angepasst sind, um verbunden zu werden mit entsprechenden Untersuchungspunkten, die Pitch-Wandlerplatte (9) eine erste Referenzmarkierung (19) hat an einer Position zum Ermöglichen einer Abbildungserstellung durch Abbildungsmittel (11);
Montieren einer Positionierungsplatte (9) an dem Führungsmittel (8) der unteren Spannvorrichtung an dem Ort, an dem eine Leiterplatte zu Montieren ist, wobei die Positionierungsplatte (7) eine zweite Referenzmarkierung (17) an einer Position entsprechend der ersten Referenzmarkierung (19) hat;
Antreiben einer von der oberen Spannvorrichtung und unteren Spannvorrichtung in vertikaler Richtung, um die Pitch-Wandlerplatte (9) und die Referenzplatte miteinander in Eingriff zu bringen;
Aufnehmen überlappender Abbildungen der ersten Referenzmarkierung (19) und der zweiten Referenzmarkierung (17) während die Pitch-Wandlerplatte (9) und die Positionierungsplatte (7) in Eingriff stehen;
Berechnen des Betrags und der Richtung der Fehlausrichtung zwischen den Positionierungsplatten (7) und der Pitch-Wandlerplatte (9) basierend auf den angenommenen überlappenden Abbildungen;
Einstellen der relativen Horizontalposition der unteren Spannvorrichtung und der oberen Spannvorrichtung basierend auf dem Ergebnis der Berechnung zum Anpassen der Untersuchungsseitenelektroden an die entsprechenden Untersuchungspunkte.

4. Verfahren nach Anspruch 3,
**dadurch gekennzeichnet, dass**
falls die obere Spannvorrichtung (21) einen Universalverschiebemechanismus umfasst und die Pitch-Wandlerplatte (9) mit einem elektrisch leitfähigen Gummiabschnitt (9r) an einer Position entsprechend dem Elektrodenbereich, das Berechnen des Betrags der Fehlausrichtung unterteilt ist in die folgenden Schritte:
a) Bereitstellen eine Musterreferenzmarkierung (29a) auf einem Film (29), mit dem der leitfähige Gummiabschnitt (9r) ausgebildet ist in einem Muster, wobei die Musterreferenzmarkierung (29a) in Bezug auf den leitfähigen Gummiabschnitt (9r) angeordnet ist;
b) Anordnen des Films derart, dass sein Muster ausgerichtet ist zu dem Muster des leitfähigen Gummiabschnitts (9r), und
c) Aufnehmen von Abbildungen der Musterreferenzmarkierung (29a) und der oberen Referenzmarke (19) und Messen des Betrags der Fehlausrichtung der Musterreferenzmarkierung (29a) und der oberen Referenzmarkierung (19).

## Revendications

1. Agencement d'examen de carte de circuit imprimé destiné à examiner une conductivité électrique entre des points d'examen sur un motif de circuit formé dans une région d'examen sur une carte de circuit imprimé à examiner, ledit agencement comprenant :
un gabarit supérieur s'étendant pratiquement horizontalement (21) comportant une région d'électrodes où une pluralité de sondes sont disposées suivant des pas universels,
un gabarit inférieur (23) comportant un moyen de guidage pour supporter la carte de circuit imprimé à une position pratiquement horizontale sur celui-ci,
**caractérisé par**
une carte de conversion de pas (9) montée de façon interchangeable sur ledit gabarit supérieur, ladite carte de conversion de pas comportant des électrodes du côté sondes disposées sur la face supérieure de la carte à relier aux sondes et des électrodes du côté examen disposées sur la face inférieure de la carte, devant être amenées jusqu'en contact avec les points d'examen, lesdites électrodes du côté sondes étant agencées pour s'adapter au pas universel des sondes du gabarit supérieur, lesdites électrodes du côté examen étant agencées pour être reliées aux points d'examen correspondants sur le motif de circuit,
une première marque de référence (19) formée sur ladite carte de conversion de pas (9),
une plaque de positionnement amovible (7) maintenue sur le gabarit inférieur à la place de la carte de circuit imprimé à tester et comportant une seconde marque de référence (17) située à une position spécifiée par rapport à une région correspondant à la région d'examen de la carte de circuit imprimé, ladite seconde marque de référence (17) étant formée à une position telle qu'elle soit alignée avec la première marque de référence (19) lorsque la carte de conversion de pas est à une position correspondante par rapport à la plaque de positionnement (7) où les électrodes du côté examen sont alignées avec les points d'examen sur la carte de circuit devant être mise à la place de la plaque de positionnement (7),
un moyen d'entraînement vertical (27) destiné à provoquer un déplacement relatif dudit gabarit supérieur (21) et dudit gabarit inférieur (23) pour amener ladite plaque de référence jusqu'en contact avec ladite carte de conversion de pas,
un moyen d'entraînement horizontal (2) destiné à provoquer un déplacement relatif desdits gabarit supérieur (21) et gabarit inférieur (23) dans des directions horizontales,
un moyen de formation d'images (11) associé à l'un d'un gabarit supérieur (21) et d'un gabarit inférieur (23) afin de former des images en chevauchement desdites première et seconde marques de référence lorsque ladite plaque de positionnement (7) est en contact avec ladite carte de conversion (9),
un moyen (123) destiné à calculer la direction et la valeur du défaut d'alignement entre ladite plaque de positionnement (7) et ladite carte de conversion de pas (9) sur la base des images en chevauchement formées par ledit moyen de formation d'images (11), et
un moyen de commande destiné à commander le moyen d'entraînement horizontal (27) conformément à la sortie dudit moyen de calcul (123) pour amener lesdits gabarit supérieur (21) et gabarit inférieur (23) jusqu'à la position relative qui fait correspondre la carte de conversion (9) à la plaque de référence (7).

2. Agencement d'examen de carte de circuit imprimé selon la revendication 1, **caractérisé en ce que**
la marque de référence supérieure (19) est formée par un trou traversant dans la région d'électrodes située à l'extérieur par rapport à la carte de conversion de pas (9) et **en ce que** la marque de référence inférieure (17) est formée par un trou traversant présentant un diamètre plus petit que celui de la marque de référence supérieure (19).

3. Procédé destiné à positionner horizontalement une carte de conversion de pas (9) par rapport à une carte de circuit imprimé devant être examinée, avec un dispositif d'examen de carte de circuit destiné à examiner une conductivité électrique entre des points d'examen sur un motif de circuit sur ladite carte de circuit imprimé, ledit dispositif comprenant un gabarit supérieur s'étendant pratiquement horizontalement (21) comportant une région d'électrodes où une pluralité de sondes sont disposées suivant des pas universels, et un gabarit inférieur (23) comportant un moyen de guidage (8) destiné à supporter horizontalement ladite carte de circuit imprimé, et un moyen de formation d'images (11) associé à l'un du gabarit supérieur et du gabarit inférieur, le procédé comprenant les étapes consistant à :
monter la carte de conversion de pas (9) sur ledit gabarit supérieur (21), ladite carte de conversion de pas (9) comportant des électrodes du côté sondes disposées sur la face supérieure de la carte de circuit imprimé de façon à être reliées aux sondes et des électrodes du côté examen disposées sur la face inférieure de la carte de circuit imprimé devant être amenées jusqu'en contact avec les points d'examen, lesdites électrodes du côté sondes étant agencées pour s'adapter au pas universel des sondes du gabarit supérieur (21), lesdites électrodes du côté examen étant conçues pour être reliées aux points d'examen correspondants, ladite carte de conversion de pas (9) comportant une première marque de référence (19) à une position permettant une formation d'images par ledit moyen de formation d'images (11),
monter une plaque de positionnement (7) sur le moyen de guidage du gabarit inférieur (8) à l'emplacement où une carte de circuit imprimé doit être montée, ladite plaque de positionnement (7) comportant une seconde marque de référence (17) à une position correspondant à ladite première marque de référence (19),
entraîner l'un desdits gabarit supérieur et gabarit inférieur verticalement pour amener ladite carte de conversion de pas (9) et ladite plaque de référence en contact l'une avec l'autre,
prendre des images en chevauchement de ladite première marque de référence (19) et de ladite seconde marque de référence (17) pendant que lesdites carte de conversion de pas (9) et plaque de positionnement (7) sont en contact,
calculer la valeur et la direction du défaut d'alignement entre ladite plaque de positionnement (7) et ladite carte de conversion de pas (9) sur la base des images prises en chevauchement,
ajuster la position horizontale relative desdits gabarit inférieur et gabarit supérieur sur la base du résultat du calcul afin de faire correspondre les électrodes du côté examen aux points d'examen correspondants.

4. Procédé selon la revendication 3, **caractérisé en ce que** dans le cas où le gabarit d'examen supérieur (21) comprend un mécanisme de déplacement universel et la carte de conversion de pas (9) avec une partie de caoutchouc électriquement conducteur (9r) à une position correspondant à la région d'électrodes, le calcul de la valeur de défaut d'alignement est sous-divisé en les étapes suivantes :
a) prévoir une marque de référence de motif (29a) sur un film (29) avec lequel la partie de caoutchouc conducteur (9r) est formée suivant un motif, la marque de référence de motif (29a) étant positionnée par référence à la partie de caoutchouc conducteur (9r),
b) placer le film de telle sorte que son motif soit aligné avec le motif de la partie de caoutchouc conducteur (9r), et
c) prendre des images de la marque de référence de motif (29a) et de la marque de référence supérieure (19) et mesurer la valeur du défaut d'alignement de la marque de référence de motif (29a) et de la marque de référence supérieure (19).
